# EUROPEAN PATENT SPECIFICATION

(11) **EP 0 961 168 B1**
(45) Date of publication and mention of the grant of the patent: **08.04.2009**
(21) Application number: 98303907.4
(22) Date of filing: 18.05.1998
(51) Int. Cl.: G03F 1/00

(54) **Method for repair of photomasks**
Methode zum Reparieren von Photomasken
Méthode pour réparer des masques de photogravure

(43) Date of publication of application: 01.12.1999
(73) Proprietor: International Business Machines Corporation, Armonk, NY 10504 (US)
(72) Inventor: Grenon, Brian J., Colchester, Vermont 05446 (US); Haight, Richard A., Mahopac, New York 10541 (US); Hayden, Dennis M., Essex Junction, Vermont 05452 (US); Hibbs, Michael S., Westford, Vermont 05494 (US); Levin, Peter J., Winooski, Vermont 05404 (US); Neary, Timothy E., Essex Junction, Vermont 05452 (US); Rochefort, Raymond A., South Burlington, Vermont 05403 (US); Schmidt, Dennis A., South Burlington, Vermont 05403 (US); Smolinski, Jacek G., Jericho, Vermont 05465 (US); Wagner, Alfred, Brewster, New York 10509 (US)
(74) Representative: Ling, Christopher John

(56) References cited:
- EP-A- 0 599 367
- DE-A- 3 705 360
- YANG B ET AL: "High resolution UV laser repair of phase shifting photomasks" 14TH ANNUAL SYMPOSIUM ON PHOTOMASK TECHNOLOGY AND MANAGEMENT, SANTA CLARA, CA, USA, 14-16 SEPT. 1994, vol. 2322, pages 35-47, XP002080959 ISSN 0277-786X, Proceedings of the SPIE - The International Society for Optical Engineering, 1994, USA
- PREUSS S ET AL: "Sub-picosecond UV laser ablation of metals" APPLIED PHYSICS A (MATERIALS SCIENCE PROCESSING), JULY 1995, GERMANY, vol. D61, no. 1, pages 33-37, XP002080958 ISSN 0947-8396
- PATENT ABSTRACTS OF JAPAN vol. 012, no. 259 (P-733), 21 July 1988 & JP 63 047769 A (OKI ELECTRIC IND CO LTD), 29 February 1988
- PATENT ABSTRACTS OF JAPAN vol. 013, no. 012 (P-812), 12 January 1989 & JP 63 218959 A (SHARP CORP), 12 September 1988
- PATENT ABSTRACTS OF JAPAN vol. 010, no. 228 (E-426), 8 August 1986 & JP 61 063029 A (SANYO ELECTRIC CO LTD;OTHERS: 01), 1 April 1986
- PATENT ABSTRACTS OF JAPAN vol. 014, no. 337 (P-1079), 20 July 1990 & JP 02 115842 A (HITACHI LTD), 27 April 1990
- PATENT ABSTRACTS OF JAPAN vol. 010, no. 091 (E-394), 9 April 1986 & JP 60 235422 A (SHARP KK), 22 November 1985

## Description

### Field of the Invention

This invention generally relates to a method of repairing defects in photomasks. More particularly, it relates to the use of short duration laser pulses to repair opaque defects on photomasks.

### Background of the Invention

Photomasks are extensively used in the fabrication of integrated circuits on semiconductor wafers. Standard photomasks include a patterned absorbing or opaque film on a transparent substrate. A metal, such as chromium, having a thickness on the order of about 100nm is often used as the opaque film. Nickel and aluminium are also used. A transparent material, such as quartz, is often used as the substrate, though materials such as glass and sapphire can also be used. Phase shift photomasks may include in addition to patterned chromium on quartz, means to change the phase of light near the chromium edge, such as an etched region in the quartz or a transparent layer on the quartz near a chromium edge. Phase shift photomasks can also include, instead of a totally opaque material, an absorbing material, also called an attenuator, that permits transmission of a small fraction of the light.

The fabrication of photomasks usually involves a blanket deposition of a thin film of the chromium opaque film on the quartz substrate. The chromium is then coated with photoresist, which is exposed with a high resolution technique, such as an electron beam, and developed to form the desired pattern in the resist. This pattern is then transferred into the chromium by etching, leaving opaque and transparent regions on the mask.

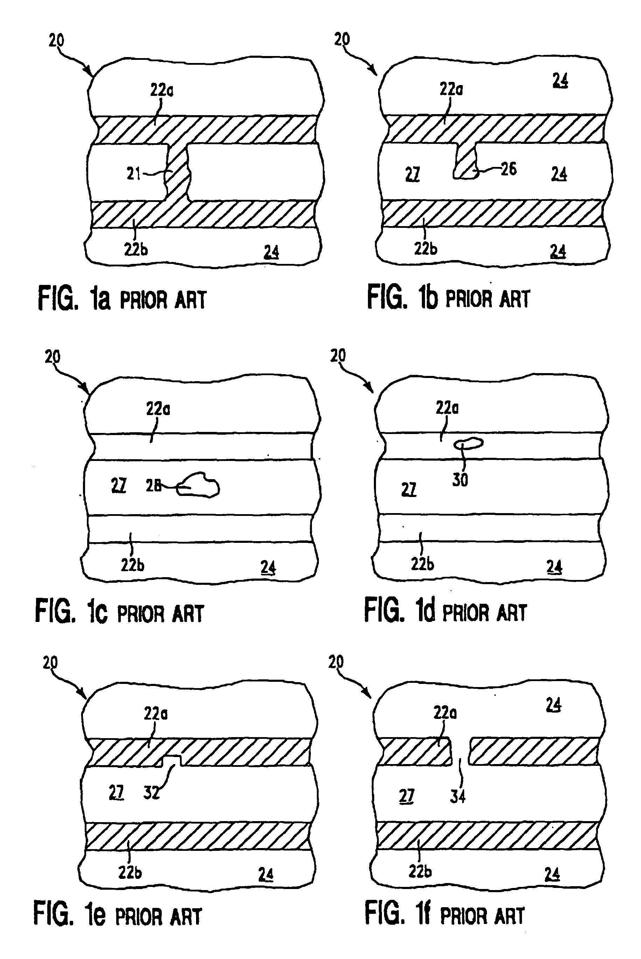

The photomask manufacturing process usually has imperfections, and defects are therefore frequently encountered during inspection of the photomasks. Defects are categorized as either "clear defects," or "opaque defects." Clear defects are regions that are designed to have the chromium but which actually do not have chromium. Opaque defects are regions that are designed to be clear of chromium but which actually do have chromium. FIG. 1 illustrates six of the most common defects seen on photolithography masks: FIG. 1a shows mask 20 having opaque bridge 21 between chromium lines 22a and 22b on quartz substrate 24; FIG. 1b shows opaque extension 26 extending from line 22a into transparent region 27 between lines 22a and 22b; FIG. 1c shows isolated opaque spot 28 in transparent region 27; FIG. 1d shows pinhole 30 in line 22a; FIG. le shows clear extension 32 into line 22a; and FIG. 1f shows clear bridge 34 extending across line 22a.

Masks having sufficiently large structures can be repaired using a technique described in US Patent 3,748,975, to Tarabocchia, in which photoresist is applied to the mask and exposed in a rectangular region including the defect to either open up a window for etching opaque defects away or to leave a region of tinted negative photoresist to fill in clear defects. However, for opaque and clear defects that are attached to metal lines normal process variations in the exposure, develop, and etch steps are too great to remove just the required amount of defect and provide a line having the desired shape within the tolerance required of present and future masks. For example, masks are currently being generated with lines having a width of .3um that typically have a tolerance in that width in the range 10% or, more preferably 5%. This precision is not achievable with standard photolithographic techniques, and the repair is likely either to leave unwanted material on the mask or to remove wanted material from the adjacent opaque region. Thus, present masks have been repaired using highly focused beams of photons or ions.

More specifically, opaque defect repair currently involves laser evaporation or ablation or focused ion beam (FIB) sputtering of the unwanted chromium in defect regions such as opaque bridge 21, opaque extension 26, and opaque spot 28. However, as with photolithographic processes, because the resolution of a laser is limited, if the opaque defect is connected to an adjacent chromium line (as in FIGs. 1a and 1b), laser ablation may damage that adjacent line, removing some wanted chromium from the line. In addition, because a great deal of thermal energy is transmitted with the laser beam, the laser ablation step not only melts and vaporizes the unwanted metal defect region, it also damages and removes a layer of quartz underlying and adjacent the opaque defect, producing roughness in the quartz, as described in a paper "Effect of Laser Mask Repair Induced Residue and Quartz Damage in Sub half-micron DUV Wafer Process," by Pei-yang Yan, et al., Proceedings of the 15th Annual Symposium on Photomask Technology and Management, September 20-22, 1995, SPIE Volume 2621, p. 158-166. This damaged region of the quartz is also responsible for reduced transmission and altered phase of transmitted light.

As an alternative to laser ablation, FIB offers a very controlled process for sputtering a small region of unwanted material. The ion beam can be focused to a much smaller size than the laser beam. In addition, the ion beam physically sputters material, transmitting very little thermal energy to the mask; thus, the quartz is not pitted. However, there are several problems that limit the use of FIB for mask repair. First, because masks are formed on quartz substrates, an insulating material, the ion beam rapidly charges the surface, and both the ability to aim subsequent ions and to use the ion beam to image the results is degraded. Second, while an opaque defect is being removed, quartz at the edge of the defect is attacked at the same rate, and the result is a "river bed" or trench of damaged quartz around the defect, the quartz in this region having altered transmission and phase. Third, the focused ion beam species is typically gallium, and gallium has been found implanted into the quartz when the opaque defect is removed, causing transmission losses. Fourth, the sputtering of material by the ion beam leads to ejection of material in all directions, and some of this ejected material comes to rest on adjacent edges as described in an article by JME Harper, et al., "Method for Improving Resolution of Focused Ion Beam Mask Repair Process," IBM Technical Disclosure Bulletin, v33, n10a, March, 1991, p174-176.

Yang B et al: "High resolution UV laser repair of phase shifting photomasks" 14TH ANNUAL SYMPOSIUM ON PHOTOMASK TECHNOLOGY AND MANAGEMENT, SANTA CLARA, CA, USA, 14-16 SEPT. 1994, vol. 2322, pages 35-47, Proceedings of the SPIE - The International Society for Optical Engineering, 1994, USA discloses a process for repairing defects on phase shifting masks using laser pulse durations of 10ns.

Preuss S et al: "Sub-picosecond UV laser ablation of metals" APPLIED PHYSICS A (MATERIALS SCIENCE PROCESSING), JULY 1995, GERMANY, vol. D61, no. 1, pages 33-37, discloses laser ablation of metals using short ultraviolet laser pulses of 0.5ps duration. It does not address the use of such ablation on a sensitive underlying substrate.

Clear defects can be repaired using a beam stimulated deposition process such as laser deposition or focused ion beam (FIB) induced deposition. These processes typically involve the decomposition of volatile organometallic complexes for which decomposition can be induced by the beam. Mask repair systems for laser deposition and FIB deposition have been commercially available for many years and the processes are well known in the art. However, inventors of the present invention have found that a thin halo of deposited material is found adjacent the laser repaired region. The halo is the result of deposition along the periphery of the laser spot where there is a low but non negligible light intensity. Thus, the edges of laser deposited material are difficult to control and trimming is usually required. This trimming step introduces the same kinds of problems and defects seen when removing other opaque defects.
Similarly, while FIB deposition to repair clear defects is more controllable than laser deposition, because the ion beam current profile also has a long tail which extends well beyond the nominal beam diameter, material is deposited in a relatively large area surrounding the intended deposit, as described in an article "Elimination of Excess Material during Focused Ion Beam Induced Deposition," by P.G. Blaunder, IBM Technical Disclosure Bulletin, v 39, n1, January, 1996, p. 287-290. This peripheral film is a fraction of the thickness of the intended deposit, but often must be removed to avoid degradation of transmission in surrounding clear regions. Removal of the peripheral film, or "halo" requires an extra step which adds to the complexity and time required for the repair process and introduces another possibility for damaging the quartz or otherwise introducing defects. In addition, because the quartz substrate charges during ion beam processing, the ion beam can be deflected and the repair patch will therefore not be located where expected.

One proposed clear defect repair technique, described in US patent 4,200,668, to Segal et al. (the '668 Patent), provides for repairing pin holes in the metal of a photomask by depositing resist on the mask, opening a window exclusively in the region of the pin hole by burning through the resist in that region with a laser, etching in the window to remove additional metal, thereby widening the pinhole and providing a more adhesive surface, depositing an opaque material on the entire surface, and then lifting off the opaque material on the resist, leaving it in the window adhering to the adjacent metal surrounding the pin hole. While this repair process is suitable for isolated pinhole defects, it is not adequate for clear defects at the edge of a metal line that required accurate reshaping and aligning, such as the clear extension and clear bridge of FIGs le and 1f.

Thus, a better solution is needed that provides a more reliable method of correcting opaque defects on photomasks, and this solution is provided by the following invention.

### Disclosure of the Invention

The invention provides a method of repairing a defect on a mask, the method comprising the steps of:
(a) providing a transparent substrate comprising a surface having a first region and a second region, a light absorbing first material covering said first region and not covering said second region;
(b) inspecting the mask and detecting an opaque defect on the mask, said defect in a defect region; and
(c) shining a plurality of laser pulses on said opaque defect region to ablate said defect, said laser pulses having a pulse duration of less than 10 picoseconds to remove said defect without damaging said substrate underlying said defect.

### Brief Description of the Drawings

The invention will now be described, by way of example only, with reference to the accompanying drawings, in which:
FIGs. 1a-1f are top views of six types of mask defects known in the prior art;
FIGs. 2a is a cross sectional view of the opaque defect of FIG. 1b;
FIG. 2b is a cross sectional view of a step of repairing an opaque defect according to a second embodiment of the present invention by sequentially laser ablating layers of the defect with a short pulse laser;
FIG. 2c is a top view of the step of FIG. 2b;
FIG. 2d is a cross sectional view of an etch step for removing a final layer of the opaque defect of FIG. 2a;

### Detailed Description of the Invention

The present invention provides a method for the repair of opaque defects. In the method, a coating may be used that protects the mask during subsequent laser ablating. The coating is deposited on the chrome lines of the mask. A short duration laser pulse is used with or without a protective coating.

Prepositions, such as "on," "over," and "under" are defined with respect to a planar surface of the mask, regardless of the orientation the mask is actually held. A layer is on another layer even if there are intervening layers.

Applicants of the present invention have discovered that laser ablation of opaque defects can cause damage in addition to the damage to adjacent lines and to the quartz that was described hereinabove. Applicants discovered a stain in the neighbourhood of laser ablated opaque defects and found that the stain significantly reduced transmission in those regions, particularly when the mask is used for exposure at short wavelengths, such as 248nm and 365nm. Applicants then characterized the stain and found it to be a redeposition of laser ablated material that falls back onto the mask as fallout.

The present invention provides a process for the repair of opaque defects by directly repairing isolated opaque defects and by converting attached opaque defects into clear defects. The invention also provides processes for repair of clear defects formed during opaque defect repair steps.

Applicants will first summarize the various embodiments of the invention before embarking on a detailed description of each embodiment with reference to the drawings. In one embodiment, the mask is coated with a polymeric material, such as photoresist, or with a thin layer of another selectively etchable material, such as aluminum, copper, or titanium. If resist is used, it is exposed with a laser and developed to open a window over opaque defects. Alternatively, the coating can be opened by laser ablation while remaining portions of the coating protect clear regions of the mask from ablation fallout. In either case a laser is used to ablate the opaque defect while the coating continues to protect other portions of the mask from fallout damage.

The coating protects non-defective portions of the mask since laser ablation fallout falls on the coating instead of directly on clear regions of the mask. Also, during a laser deposition process to fill clear defects, any halo from the laser deposition will be lifted off when the coating is etched. A reactive ion etch (RIE) or sputtering step can also be used to remove the halo on the coating before the liftoff step.

In the develop or ablation processes, the coating may inadvertently be opened extending to a region beyond the opaque defect. This does not cause a problem for an unattached opaque defect. But for an attached opaque defect the opened region may include a portion of a wanted line adjacent the attached opaque defect.

Thus, for attached opaque defects another step is frequently needed to repair created clear defects by depositing material along the desired pattern to rebuild the desired images. A laser deposition or a FIB deposition tool can be used for this rebuilding process. A coating is used during each of these deposition process steps to protect adjacent clear regions of the mask from unwanted deposits. Furthermore, for FIB deposition, the coating is conductive to avoid charging in the ion beam.

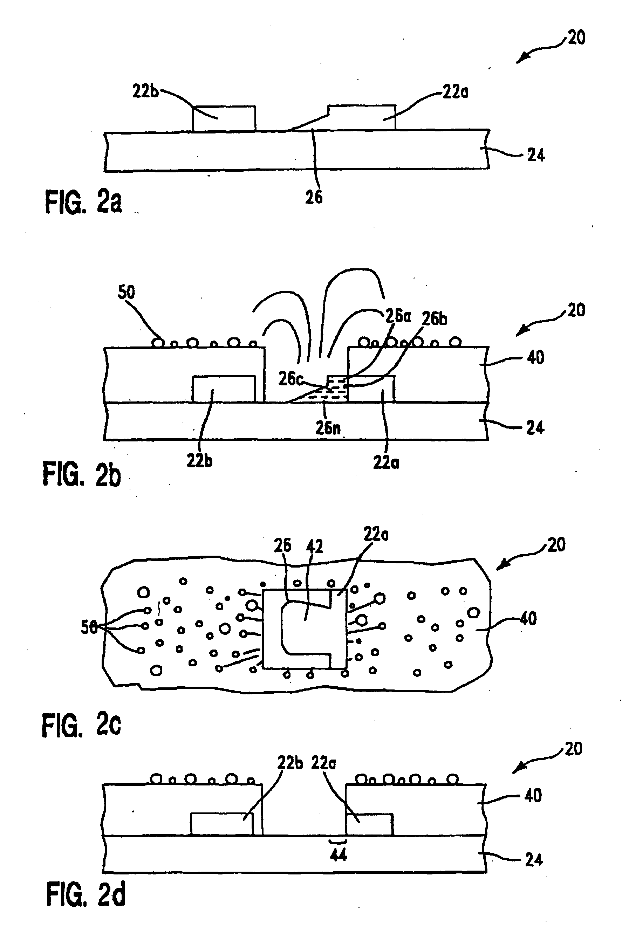

A femtosecond laser, as described in a paper by B. N. Chichkov et al, "Femtosecond, Picosecond and Nanosecond Laser Ablation of Solids," Appl. Phys. A, Material Sci. Process. (Germany) Vo. 63, No. 2, August, 1996, p. 109-115, can be used to provide a much more controlled laser ablation of the attached opaque defect of FIG. 1b (also shown in cross section in FIG. 2a). In the process, coating 40 is first ablated. Defect 26 is then ablated in a series of pulses, rather than in a single pulse, removing one layer 26a, 26b, 26c at a time using the femtosecond laser, as illustrated schematically in FIGs 2b and 2c. The presence of at least one additional layer of defect chromium under each layer that is ablated protects underlying quartz 24 from pitting during each of the femtosecond laser ablation pulses. Before coating 40 is stripped, the final layer of opaque defect 26 is removed using a very brief chemical or dry etch step as shown in FIG. 2d. The present inventors have found that laser ablation of a thin layer of defect, such as layer 26n, does not cause quartz pitting. Thus, the laser ablation delayering can proceed to completion. Pitting damage to quartz substrate 24 is avoided.

In addition, laser ablation systems have a standard edge lock to prevent or limit laser ablation of an adjacent wanted line such as line 22a. On some tools the edge lock automatically aligns to the edge of the desired line. In other systems the alignment is done manually by an operator. In the manual system an operator shines a beam of visible light onto the defect to be ablated through a rectangular aperture having controllable length, width, and rotation to provide a spot marker. The operator aligns the edge of the spot marker beam to the edge of the line to within a small tolerance. The laser is then shined through the aperture and ablates in the spot marker region to within a small tolerance. Currently the repair tolerance is in the range of 50 to 100nm. This tolerance for the repair is shown in FIGs 2b and 2c as an exposed portion of line 22a and as clear defect 44 in line 22a in FIG. 2d. Of course, it could also be a small opaque defect extending out from line 22a. Whether a clear repair in region 44 is needed or whether a second ablation step is needed depends on the magnitude of the tolerance and the results of the first ablation. Usually such a repair is not needed because a small "defect" that is within the tolerance cannot be found by inspection tools and, more importantly, is too small to print on the chip.

Also, as described hereinabove, coating 40 prevents fallout 50 from damaging clear regions 27 of mask 20; fallout 50 will instead land on coating 40 and be lifted off when coating 40 is later stripped. Fallout has been found not to be a problem in the immediate vicinity of the defect site (such as within window 42 in coating 40) because of the laser energy directed there.

## Claims

1. A method of repairing a defect (26) on a mask (20), the method comprising the steps of:
(a) providing a transparent substrate (24) comprising a surface having a first region and a second region, a light absorbing first material covering said first region (22a, 22b) and not covering said second region (27); and
(b) inspecting the mask and detecting an opaque defect on the mask, said defect in a defect region;
**characterised by**:
(c) shining a plurality of laser pulses on said opaque defect region to ablate said defect, said laser pulses having a pulse duration of less than 10 picoseconds, to remove said defect without damaging said substrate underlying said defect.

2. A method as claimed in claim 1, further comprising before said shining step (c) the step of providing a second material (40) on said substrate on said second region (27), said second material for temporary protection of said second region from fallout during said shining step (c), said second material selectively removable with respect to said first material and said substrate (24).

3. A method as claimed in claim 1, wherein said laser pulses have a duration of less than 200 femtoseconds.

4. A method as claimed in claim 1, wherein said laser pulses ablate said defect (26) layer by layer.

## Patentansprüche

1. Verfahren zum Reparieren eines Defekts (26) auf einer Maske (20), wobei das Verfahren die folgenden Schritte umfasst:
(a) Bereitstellen eines transparenten Substrats (24), welches eine Fläche umfasst, die eine erste Region und eine zweite Region aufweist, wobei ein Licht absorbierendes erstes Material die erste Region (22a, 22b) bedeckt und die zweite Region (27) nicht bedeckt; und
(b) Untersuchen der Maske und Erkennen eines opaken Defekts auf der Maske, wobei sich der Defekt in einer Defektregion befindet;
**gekennzeichnet durch**:
(c) Schicken mehrerer Laserimpulse auf die Region des opaken Defekts, um den Defekt abzutragen, wobei die Laserimpulse eine Impulsdauer von weniger als 10 Pikosekunden aufweisen, um den Defekt zu entfernen, ohne das unter dem Defekt liegende Substrat zu beschädigen.

2. Verfahren nach Anspruch 1, welches vor dem Schritt des Schickens der Laserimpulse (c) ferner den Schritt des Bereitstellens eines zweiten Materials (40) auf dem Substrat auf der zweiten Region (27) umfasst, wobei das zweite Material dem vorübergehenden Schutz der zweiten Region vor Absprengungen während des Schrittes des Schickens der Laserimpulse (c) dient, wobei das zweite Material in Bezug auf das erste Material und das Substrat (24) selektiv entfernbar ist.

3. Verfahren nach Anspruch 1, wobei die Laserimpulse eine Dauer von weniger als 200 Femtosekunden aufweisen.

4. Verfahren nach Anspruch 1, wobei die Laserimpulse den Defekt (26) Schicht für Schicht abtragen.

## Revendications

1. Procédé de réparation d'un défaut (26) sur un masque (20), le procédé comprenant les étapes consistant à :
(a) fournir un substrat transparent (14) comprenant une surface comportant une première région et une deuxième région, un premier matériau absorbant la lumière couvrant ladite première région (22a, 22b) et ne couvrant pas ladite deuxième région (27), et
(b) inspecter le masque et détecter un défaut opaque sur le masque, ledit défaut se trouvant dans une région de défaut,
**caractérisé par** :
(c) le fait d'orienter une pluralité d'impulsions laser sur ladite région de défaut opaque pour éliminer par ablation ledit défaut, lesdites impulsions laser ayant une durée d'impulsion inférieure à 10 picosecondes pour éliminer le ledit défaut sans endommager ledit substrat sous-jacent par rapport audit défaut.

2. Procédé selon la revendication 1, comprenant en outre, avant ladite étape d'orientation (c), l'étape consistant à fournir un deuxième matériau (40) sur ledit substrat sur ladite deuxième région (27), ledit deuxième matériau étant destiné à une protection temporaire de ladite deuxième région vis-à-vis des retombées de ladite étape d'orientation (c), ledit deuxième matériau pouvant être éliminé de manière sélective par rapport audit premier matériau et audit substrat (24).

3. Procédé selon la revendication 1, dans lequel lesdites impulsions laser ont une durée inférieure à 200 femtosecondes.

4. Procédé selon la revendication 1, dans lequel lesdites impulsions laser éliminent par ablation ledit défaut (26) couche par couche.
